# FASCICULE DE BREVET EUROPEEN

(11) **EP 0 605 299 B1**
(45) Date de publication et mention de la délivrance du brevet: **10.09.1997**
(21) Numéro de dépôt: 93403153.5
(22) Date de dépôt: 23.12.1993
(51) Int. Cl.: C23C 14/00, C23C 14/54

(54) **Méthode de réglage d'un procédé de pulvérisation cathodique réactive**
Verfahren zur Regelung eines reaktiven Sputterprozesses
Method for controlling a reactive sputtering process

(30) Priorité: 30.12.1992 FR 9215924
(43) Date de publication de la demande: 06.07.1994
(73) Titulaire: INSTITUT NATIONAL POLYTECHNIQUE DE LORRAINE, F-54501 VANDOEUVRE Cedex (FR)
(72) Inventeur: Stauder, Bruno, F-54210 Saint-Nicolas (FR); Perry, Frédéric, F-54600 Villers-les-Nancy (FR)
(74) Mandataire: Bloch, Gérard

(56) Documents cités:
- EP-A- 0 275 018
- EP-A- 0 430 229
- EP-A- 0 508 359
- FR-A- 2 503 190

## Description

La présente invention, réalisée par Messieurs Bruno STAUDER, Claude FRANTZ, Alain BILLARD et Philippe PIGEAT du Laboratoire de Science et Génie des Surfaces (LSGS) - URA CNRS 1402 - Ecole des Mines de NANCY (I.N.P.L.), et Messieurs Frédéric PERRY et Gérard HENRION du Laboratoire de Physique des Milieux Ionisés (LPMI) - URA CNRS 835 - Faculté des Sciences - Université de NANCY I, concerne un procédé qui, en favorisant la stabilisation du processus physique d'élaboration, permet de contrôler la concentration en métalloïde d'un dépôt réalisé par voie physique en phase vapeur réactive à l'aide d'un plasma froid de pulvérisation d'une cible.

On connait des procédés de dépôt physique en phase vapeur réactive du type rappelé ci-dessus, parmi lesquels, à titre d'exemple, la pulvérisation magnétron réactive en courant continu ou en radiofréquence, d'une cible métallique ou semi-conductrice en présence d'un gaz réactif (O₂,N₂,CH₄,B₂H₆,SH₂ ...), vecteur de l'élément métalloïde. Le gaz plasmagène responsable de la pulvérisation de la cible est un gaz rare, par exemple l'argon. Les alliages susceptibles d'être synthétisés sont donc à base d'un métal ou d'un semi-conducteur enrichi en métalloïde (O,N,C,B,S). Quant aux composés stoechiométriques, il peut s'agir d'oxydes, de nitrures, de carbures, de borures ou de sulfures. Ces alliages ou composés peuvent être déposés sur des substrats métalliques semi-conducteurs ou isolants.

On sait que la pulvérisation d'une cible métallique ou semi-conductrice est dite réactive si elle intervient en présence d'un gaz chimiquement actif vis-à-vis de la vapeur émise par cette cible. Lorsqu'en présence d'une décharge électrique créant un plasma, on introduit un gaz réactif dans le réacteur, une fraction de ce gaz interagit avec les différentes surfaces réceptrices (parois du réacteur, substrat, cible), la fraction éventuellement excédentaire étant évacuée par le groupe de pompage.

Ceci implique que la pression partielle P_{R} de gaz réactif est inférieure à celle qui s'établirait en l'absence de décharge et que les caractéristiques électriques de la cible émettrice sont affectées à la fois par la participation croissante des espèces réactives à sa pulvérisation, par la modification éventuelle de la nature chimique de sa surface, et par un changement des conditions d'excitation et d'ionisation du gaz plasmagène.

La difficulté principale qui survient en condition de pulvérisation réactive est le maintien d'un régime stable permettant de contrôler la composition en métalloïde du dépôt ou de sa stoechiométrie lorsqu'il s'agit d'un composé. En effet, l'expérience ainsi que le calcul basé sur des modèles récents de pulvérisation magnétron réactive montrent que celle-ci correspond à un phénomène non linéaire qui se traduit par un effet d'hystérésis apparaissant sur les courbes qui lient, au débit de gaz réactif D_{R} introduit dans le réacteur, la pression partielle P_{R} de gaz réactif, la concentration C_{Me} en métalloïde du dépôt, la vitesse V_{D} de dépôt, et les caractéristiques électriques de la décharge (courant cible et tension cible pour une décharge continue ou tension d'autopolarisation pour une décharge radiofréquence).

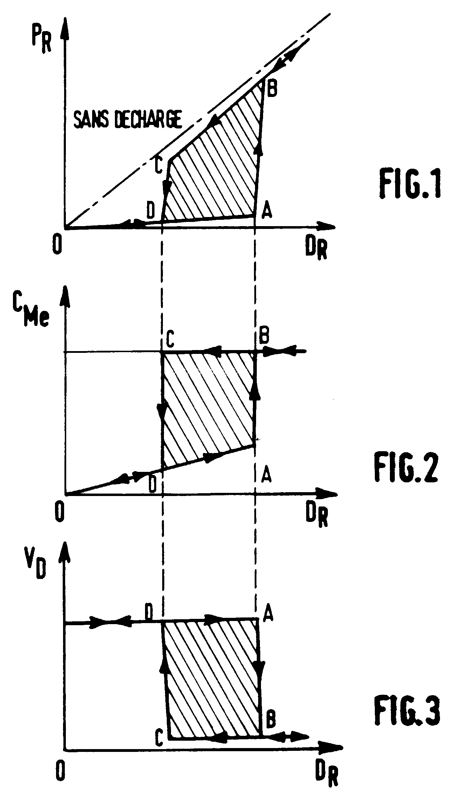

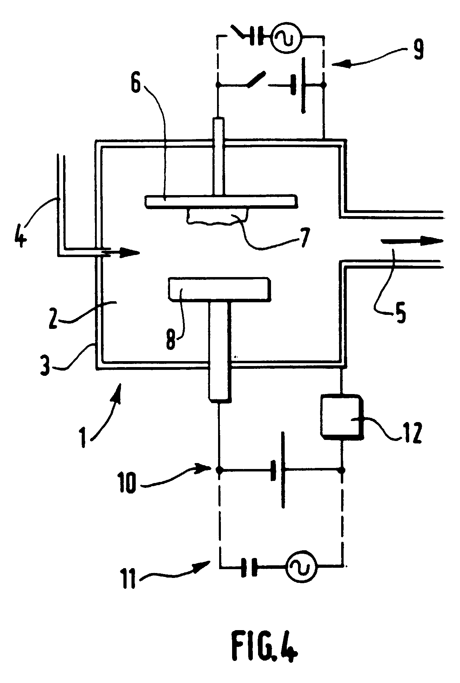

Les figures 1, 2 et 3 représentent respectivement en fonction du débit D_{R}, les grandeurs P_{R}, C_{Me} et V_{D} dans les procédés de l'état de la technique.

On distingue, sur ces courbes, deux modes de pulvérisation :
1) Pour des débits de gaz réactif inférieurs à (DR)_{A} , les espèces réactives captées par la cible sont repulvérisées avant d'avoir pu réagir avec elle pour former un produit de réaction stable : ce régime de pulvérisation, dit élémentaire (RPE), conduit à une vitesse de dépôt élevée et à un enrichissement continu du dépôt en métalloïde. Il se caractérise par une faible pression partielle de gaz réactif, celui-ci étant consommé par réaction avec la vapeur issue de la cible sur les parois et le substrat.
2) Pour des débits de gaz réactif supérieurs à (DR)_{A} , les espèces réactives réagissent très rapidement avec la cible pour former un composé superficiel stable possédant, généralement, un faible taux de pulvérisation (oxyde, nitrure, carbure, borure, sulfure) : ce régime de pulvérisation, dit de composé (RPC), se traduit par une brusque augmentation de la pression partielle P_{R} de gaz réactif due à la saturation des parois, associée à une diminution importante de la vitesse de dépôt. La concentration en métalloïde du dépôt subit une discontinuité pour atteindre sa valeur limite qui correspond à celle du composé stoechiométrique le plus riche.

Les transitions RPE → RPC et RPC → RPE qui se produisent respectivement aux débits critiques (DR)_{A} et (DR)_{C} sont instables et se traduisent par un effet d'emballement qui force le point de fonctionnement du réacteur à passer de A à B ou de C à D selon que le débit de gaz réactif augmente ou diminue. Les parties AB et CD des courbes définissent ainsi un domaine d'hystérésis d'autant plus large et abrupt que la différence entre les taux respectifs de pulvérisation de la cible dans son état élémentaire et dans son état contaminé est grande.

L'existence d'une hystérésis rend extrêmement difficile l'élaboration avec une grande vitesse de déposition du composé stoechiométrique le plus riche ou des dépôts dont la composition est située à l'intérieur du domaine hachuré de la figure 2 : en effet, seul un contrôle très sophistiqué en boucle fermée avec microprocesseur et à très faible temps de réponse permet parfois de maintenir le point de fonctionnement dans les régions d'instabilité, par exemple en régulant la tension appliquée à la cible comme dans le document EP-A-430229, ou en asservissant le débit de gaz réactif ou la puissance dissipée sur la cible à l'intensité d'une raie d'émission optique propre à un élément constitutif de la cible. Un tel moyen de contrôle possède, dans le meilleur des cas, un temps de réponse de quelques dizièmes de seconde qui, s'il convient pour l'élaboration de certains composés, s'avère souvent beaucoup trop long, par exemple dans le cas de l'alumine Al₂O₃ : en effet, l'oxygène moléculaire peut réagir avec la cible d'aluminium par un mécanisme de chimisorption très rapide puisqu'il ne faut que quelques millisecondes à une monocouche chimisorbée pour se former.

On a donc proposé de réduire, voire de supprimer, le domaine d'hystérésis. On sait qu'une augmentation de la vitesse de pompage va dans ce sens mais, malheureusement, celle-ci devient très vite prohibitive dans la plupart des cas.

Il en est de même de la diminution artificielle de l'aire totale des parois réceptrices du réacteur par l'emploi d'un manchon ou d'écrans ainsi que des moyens qui visent à augmenter la réactivité des espèces métalloïdes au voisinage du substrat en créant, par exemple, un gradient favorable de la pression partielle de gaz réactif grâce à un choix judicieux de son site d'introduction dans le réacteur : ces derniers procédés s'avèrent efficaces uniquement lorsque le gaz réactif peut interagir naturellement avec la vapeur issue de la cible comme c'est le cas, par exemple, de l'oxygène moléculaire dans son état fondamental.

La présente invention vise à pallier ces inconvénients.

A cet effet, l'invention a pour objet un procédé qui favorise la stabilisation du processus physique de déposition et permet ainsi de contrôler la concentration en métalloïde d'un dépôt sur un substrat réalisé par voie physique en phase vapeur réactive à l'aide d'un plasma froid de pulvérisation d'une cible, caractérisé par le fait que la puissance instantanée appliquée à la cible est cycliquement réduite et augmentée à basse fréquence par variation de la tension appliquée de manière à, alternativement, provoquer une réaction entre la cible et le gaz réactif, et pulvériser le produit de ladite réaction.

La réduction précitée peut aller jusqu'à une annulation. L'augmentation précitée est la conséquence d'une impulsion électrique dont la forme et l'amplitude peuvent être complexes. Par ailleurs, on entend par basse fréquence une fréquence telle qu'elle permet d'obtenir le cycle réaction-pulvérisation précitée. On distinguera en particulier l'invention des procédés de coupure des micro-arcs susceptibles de s'amorçer sur les zones les moins érodées de la cible (dans le cas d'une alimentation par une tension continue négative) aux emplacements où l'apparition d'un produit de réaction diélectrique est la plus probable, ces procédés de coupure de micro-arcs fonctionnant sur des durées très inférieures à celles de l'invention et généralement de l'ordre de la microseconde.

L'homme de métier pourra de toute manière déterminer cas par cas expérimentalement, les caractéristiques de forme, amplitude, durée et fréquence du cycle de réduction et augmentation de puissance appliqué à la cible en fonction des caractéristiques physiques du dispositif et de la nature des matériaux.

D'une manière générale, la fréquence de cette réduction de puissance est de préférence comprise entre 0,1 et 1000 Hz et la durée de cette réduction est de préférence comprise entre 100/f et 800/f millisecondes, où f est cette fréquence.

Plus particulièrement, la fréquence peut être comprise entre 1 et 100 Hz et la durée des réductions de puissance comprise entre 1 milliseconde et 800 millisecondes.

L'invention consiste donc pour l'essentiel à réaliser un auto-contrôle en temps réel de la réaction chimique susceptible de se produire à la surface de la cible et par là même du flux de vapeur issue de la cible, grâce à la superposition d'impulsions ou d'oscillations électriques de basse fréquence à la tension d'alimentation de la cible (tension continue, tension radiofréquence ou superposition des deux). Ces impulsions ou oscillations électriques de forme, amplitude, durée et fréquence convenables doivent produire une extinction du plasma ou une diminution notable de la puissance instantanée appliquée à la cible pendant une durée compatible avec les vitesses de diffusion et les temps de réaction des espèces métalloïdes du plasma avec les différentes surfaces réceptrices du réacteur (cible, substrat, parois). Elles doivent ainsi permettre la formation contrôlée d'un produit de réaction de très faible épaisseur à la surface de la cible et assurer sa pulvérisation pendant la phase suivante où le plasma est allumé.

Ce cycle de réaction - pulvérisation conduit à un régime stationnaire parfaitement stable sans phénomène d'emballement, qui réduit considérablement et souvent même élimine l'hystérésis résultant d'une réaction incontrôlée sur la surface de la cible.

Des vitesses de déposition élevées du composé stoechiométrique ou de l'alliage enrichi en métalloïde sont ainsi obtenues. Elles sont souvent voisines de celles que l'on obtient en pulvérisation non réactive pour le métal ou le semi-conducteur pur.

De plus, le procédé proposé (s'il réalise une extinction du plasma) permet de couper les micro-arcs précités. Il faut noter cependant que, pour des produits de réaction diélectriques très isolants, un système de coupure d'arcs fonctionnant de façon connue à la microseconde est préférable dans le cas de la pulvérisation en courant continu.

On décrira maintenant, à titre d'exemple non limitatif, un mode de réalisation particulier de l'invention, en référence aux dessins annexés, dans lesquels :
- les figures 1 à 3 illustrent le fonctionnement des procédés de l'état de la technique,
- la figure 4 représente schématiquement un dispositif permettant la mise en oeuvre du procédé selon l'invention,
- les figures 5a et 5b illustrent le fonctionnement de ce procédé appliqué au dépôt d'alumine, et
- les figures 6a et 6b illustrent le fonctionnement de ce procédé appliqué au dépôt de zircone.

La figure 4 montre un réacteur 1 formé d'une enceinte 2, délimitée par des parois 3. Un conduit 4 permet l'introduction dans l'enceinte 2 d'un gaz ou d'un mélange gazeux réactif ainsi que d'un gaz plasmagène, et un conduit 5 raccorde l'enceinte 2 à un groupe de pompage non représenté, assurant l'obtention du vide nécessaire.

A l'intérieur de l'enceinte 2, un porte-substrat 6 est disposé de manière à recevoir un substrat 7 en vis-à-vis d'une cible 8.

Le porte-substrat 6 peut être relié à des générateurs 9, de manière à assurer sa polarisation, soit en continu soit en alternatif radiofréquence.

La cible 8 est réalisée dans le métal ou le semi-conducteur que l'on souhaite déposer sous forme d'alliage ou de composé sur le substrat 7. La cible 8 est alimentée, soit en courant continu par un générateur 10, soit en courant alternatif radiofréquence par un générateur 11.

Le dispositif tel qu'il vient d'être décrit est bien connu dans la technique.

Selon l'invention, on prévoit en outre un dispositif 12 permettant de superposer à la tension continue négative délivrée par le générateur 10 ou à la tension en radiofréquence délivrée par le générateur 11 ou à une superposition de ces deux tensions, des impulsions ou oscillations électriques de basse fréquence.

Ce dispositif, de tout type électrique et/ou magnétique convenable permet soit de couper l'alimentation, soit de diminuer sa puissance instantanée.

Le dispositif décrit ci-dessus a été utilisé dans le cadre d'une pulvérisation réactive magnétron de cibles réalisées respectivement en aluminium et en zirconium d'un diamètre de 51 mm. La puissance appliquée était de 260 watts et la distance cible-substrat de 80 mm.

La cible était alimentée par une tension continue négative, à laquelle étaient superposées des impulsions de fréquence 50 Hertz, créant une extinction du plasma pendant 5 millisecondes.

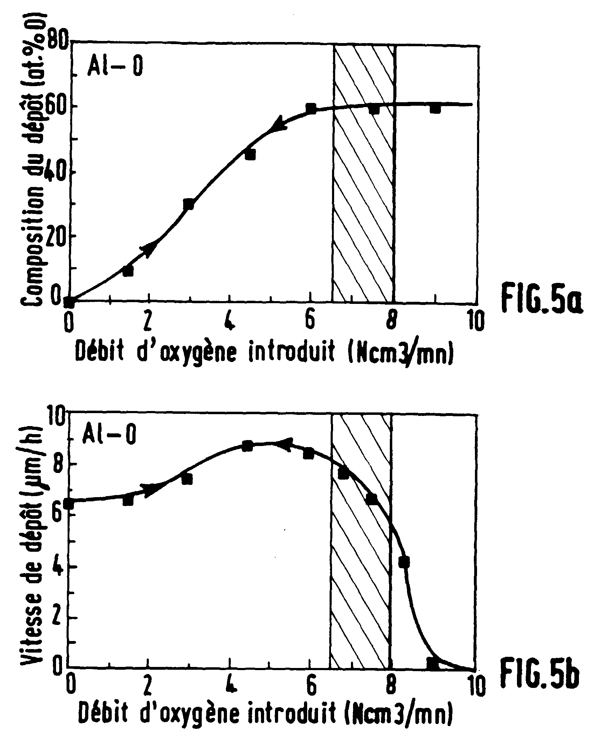

La figure 5a montre la composition du dépôt Al-O en pourcentage atonique d'oxygène dans le cas d'une cible en aluminium en fonction du débit d'oxygène introduit par la canalisation 4. Le débit d'argon et la pression totale étaient respectivement de 45 N.cm³/mn et 0,8-1Pa.

La figure 5b représente la vitesse de dépôt en fonction de ce même débit.

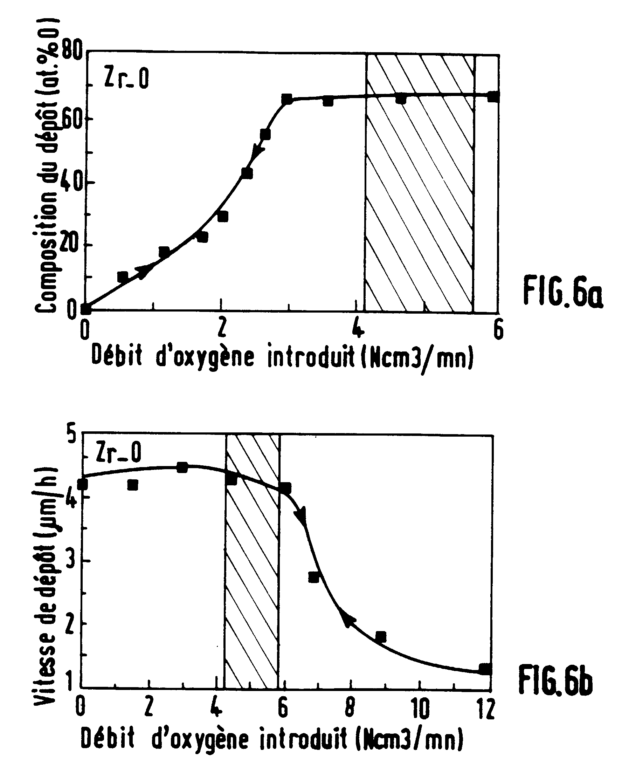

Les figures 6a et 6b sont similaires aux figures 5a et 5b dans le cas d'une cible en zirconium. Le débit d'argon et la pression totale étaient alors respectivement de 36 N.cm³/mn et 0,3-0,4 Pa.

On constate qu'il est possible de synthétiser, au voisinage de la température ambiante, des alliages de toute composition voulue, et, dans les parties hachurées des figures 5a, 5b, 6a et 6b, qu'il est plus particulièrement possible de synthétiser des composés parfaitement stoechiométriques et transparents optiquement d'alumine Al₂O₃ et de zircone ZrO₂ avec des vitesses de dépôt analogues à celles de l'aluminium ou du zirconium pur. Dans le domaine des valeurs du débit d'oxygène introduit dans le réacteur, les courbes des figures 5a, 5b, 6a et 6b sont parfaitement réversibles.

Des résultats similaires ont été obtenus lors de la synthèse du nitrure d'aluminium AlN ou de l'oxyde de type spinelle (Fe, Cr, Ni)₃O₄.

## Revendications

1. Procédé d'auto-stabilisation du processus physique de déposition permettant de contrôler l'enrichissement en métalloïde d'un dépôt réalisé sur un substrat par voie physique en phase vapeur réactive à l'aide d'un plasma froid de pulvérisation d'une cible, caractérisé par le fait que la puissance instantanée appliquée à la cible est cycliquement réduite et augmentée à basse fréquence par variation de la tension d'alimentation de manière à, alternativement, provoquer une réaction entre la cible et le gaz réactif, et pulvériser le produit de ladite réaction.

2. Procédé selon la revendication 1, appliqué au contrôle de la concentration en métalloïde de composés stoechiométriques de type céramique.

3. Procédé selon l'une quelconque des revendications 1 et 2, dans lequel la fréquence desdits cycles de réduction et augmentation de puissance instantanée est environ comprise entre 0,1 Hz et 1000 Hz.

4. Procédé selon la revendication 3, dans lequel la durée desdits cycles de réduction et augmentation de puissance instantanée est comprise entre 100/f et 800/f millisecondes, où f est ladite fréquence.

5. Procédé selon la revendication 4, dans lequel ladite fréquence est comprise entre 1 Hz et 100 Hz et ladite durée entre 1 ms et 800 ms.

6. Procédé selon l'une quelconque des revendications 1 à 5, dans lequel ladite réduction de puissance est une annulation qui provoque une extinction du plasma.

## Patentansprüche

1. Verfahren zur Selbststabilisierung des physikalischen Abscheidungsprozesses, das es ermöglicht, die Metalloid anreicherung einer Abscheidung zu steuern, die auf einem Substrat auf physikalischem Wege in einer reaktiven Dampfphase mittels eines kalten Plasmas für die Pulverisierung eines Targets erzeugt worden ist,
dadurch gekennzeichnet, daß die auf das Target einwirkende Momentanleistung durch Variation der Versorgungsspannung mit niedriger Frequenz zyklisch verringert und erhöht wird, sodaß wechselweise eine Reaktion zwischen dem Target und dem reaktiven Gas hervorgerufen und das Produkt dieser Reaktion pulverisiert wird.

2. Verfahren nach Anspruch 1,
das zur Steuerung der Nichtmetall-Konzentration stöchiometrischer Verbindungen vom Keramiktypus angewendet wird.

3. Verfahren nach einem der Ansprüche 1 und 2,
in dem die Frequenz der Zyklen der Verringerung und Erhöhung der Momentanleistung ungefähr zwischen 0,1 Hz und 1000 Hz liegt.

4. Verfahren nach Anspruch 3,
in dem die Dauer der Zyklen der Verringerung und Erhöhung der Momentanleistung zwischen 100/f und 800/f Millisekunden liegt, wobei fdie Frequenz ist.

5. Verfahren nach Anspruch 4,
in dem die Frequenz zwischen 1 Hz und 100 Hz und die Dauer zwischen 1 ms und 800 ms liegt.

6. Verfahren nach einem der Ansprüche 1 bis 5,
in dem die Leistungsverringerung eine Unterbrechung ist, die zu einer Extinktion des Plasmas führt.

## Claims

1. Method of self stabilisation of the physical process of deposition permitting control of metalloid enrichment of a deposition on a substrate produced by physical way in reactive vaporous phase with the aid of a cold plasma for pulverization of a target, characterised in that the instantaneous power applied to the target is cyclically reduced and increased at a low frequency by variation of the supply voltage in such as way as alternately to cause a reaction between the target and the reactive gas and to pulverize the product of the said reaction.

2. Method according to claim 1, applied to controlling the metalloid concentration of stoichiometric compounds of the ceramic type.

3. Method according to one of claims 1 and 2, wherein the frequency of the said cycles of reduction, and increase of instantaneous power is approximately between 0.1 Hz and 1000 Hz.

4. Method according to claim 3, wherein the duration of the said cycles of reduction and increase of instantaneous power is between 100/f and 800/f milliseconds where f is the said frequency.

5. Method according to claim 4, wherein the said frequency is between 1 Hz and 100 Hz and the said duration between 1 ms and 800 ms.

6. Method according to one of claims 1 to 5, wherein the said reduction in power is a cancellation which causes extinction of the plasma.
